# EUROPEAN PATENT APPLICATION

(11) **EP 4 456 122 A1**
(43) Date of publication of application: **30.10.2024**
(21) Application number: 24170163.0
(22) Date of filing: 15.04.2024
(51) Int. Cl.: H01L 21/74, H01L 21/768, H01L 23/48, H01L 23/535

(54) **INTEGRATED CIRCUIT DEVICES INCLUDING A BACK SIDE POWER DISTRIBUTION NETWORK STRUCTURE AND METHODS OF FORMING THE SAME**

(30) Priority: 28.04.2023 US 202363498856 P; 31.08.2023 US 202318240675
(71) Applicant: Samsung Electronics Co., Ltd., Suwon-si, Gyeonggi-do 16677 (KR)
(72) Inventor: YUN, Seungchan, San Jose, CA 95134 (US); HONG, Wonhyuk, San Jose, CA 95134 (US); PARK, Panjae, San Jose, CA 95134 (US); SEO, Kang-Ill, San Jose, CA 95134 (US)
(74) Representative: Kuhnen & Wacker Patent- und Rechtsanwaltsbüro PartG mbB

(57) **Abstract**

Integrated circuit devices and methods of forming the same are provided. The integrated circuit devices may include a transistor comprising a source/drain region on a substrate; a backside power rail spaced apart from the source/drain region; and a power contact that is between the source/drain region and the backside power rail and electrically connects the source/drain region to the backside power rail. The substrate may be between the source/drain region and the backside power rail, and a centerline in a width direction of the source/drain region is angled with respect to a centerline in a width direction of the power contact.

## Description

### BACKGROUND

The present disclosure generally relates to the field of integrated circuit devices and, more particularly, to integrated circuit devices including a backside power distribution network (BSPDN) structure.

Various structures of an integrated circuit device and methods of forming the same have been proposed to increase the integration density of the integrated circuit device. Specifically, an integrated circuit device including elements formed in a substrate or on a backside of the substrate has been proposed to simplify the middle-of-line (MOL) portion and/or the back-end-of-line (BEOL) portion of device fabrication.

### SUMMARY

An integrated circuit device comprising: a transistor comprising a source/drain region on a substrate; a backside power rail spaced apart from the source/drain region, wherein the substrate is between the source/drain region and the backside power rail; and a power contact that is between the source/drain region and the backside power rail and electrically connects the source/drain region to the backside power rail, wherein a centerline in a width direction of the source/drain region is angled with respect to a centerline in a width direction of the power contact.

An integrated circuit device comprising: a transistor comprising a source/drain region; a backside power rail spaced apart from the source/drain region in a vertical direction; a backside insulator that is between the backside power rail and the source/drain region and comprises an upper surface facing the source/drain region; a first power contact that is in the backside insulator and electrically connects the source/drain region to the backside power rail; and a second power contact in the backside insulator, wherein the first power contact and the second power contact are symmetric with respect to a vertical line, and a distance between the first and second power contacts in a horizontal direction increases as a distance from the upper surface of the backside insulator increases.

A method of forming an integrated circuit device, the method comprising: providing a structure including a backside insulator and a transistor on the backside insulator, the transistor comprising a source/drain region; and forming a power contact in the backside insulator, wherein the power contact is electrically connected to the source/drain region, and wherein forming the power contact comprises: forming a power contact opening in the backside insulator; conformally forming a power contact layer along a surface of the power contact opening, the power contact layer defining an inner opening within the power contact opening; and forming an inner insulator in the inner opening.

### BRIEF DESCRIPTION OF THE DRAWINGS

FIG. 1 is a cross-sectional view of an integrated circuit device according to some embodiments.
FIG. 2 is a flow chart of methods of forming an integrated circuit device according to some embodiments.
FIGS. 3 through 9 are methods of manufacturing an integrated circuit device.
FIG. 10 is a cross-sectional view of an integrated circuit device according to some embodiments.
FIG. 11 is a cross-sectional view of an integrated circuit device according to some embodiments.
FIG. 12 is a cross-sectional view of an integrated circuit device according to some embodiments.
FIGS. 13 through 19 are cross-sectional views illustrating methods of manufacturing an integrated circuit device.
FIG. 20 is a plan view of an integrated circuit device according to some embodiments.

### DETAILED DESCRIPTION

According to some embodiments, an integrated circuit device may include a power plug that may be formed by replacing a placeholder in a substrate. The placeholder may be formed before completing the front-end-of-line (FEOL) portion of device fabrication, and thus the power plug may be formed without increasing the complexity of the MEOL and/or BEOL portions of device fabrication. After the power plug is formed, a BSPDN structure, including a backside power rail, may be formed on the power plug and a lower surface of the substrate. The integrated circuit device may include a thick semiconductor substrate for various devices, such as passive devices. The power plug and the backside power rail may be spaced apart from each other, and power contact that electrically connects the power plug and the backside power rail may be disposed between the power plug and the backside power rail. The power contact may be formed by a conductive layer formed along a side surface of a recess (e.g., an opening) in a substrate (e.g., a semiconductor substrate or an insulator) so that the formation of the power contact may not involve forming a contact with a higher aspect ratio and/or filling a conductive layer in a contact with a high aspect ratio.

Example embodiments will be described in greater detail with reference to the attached figures.

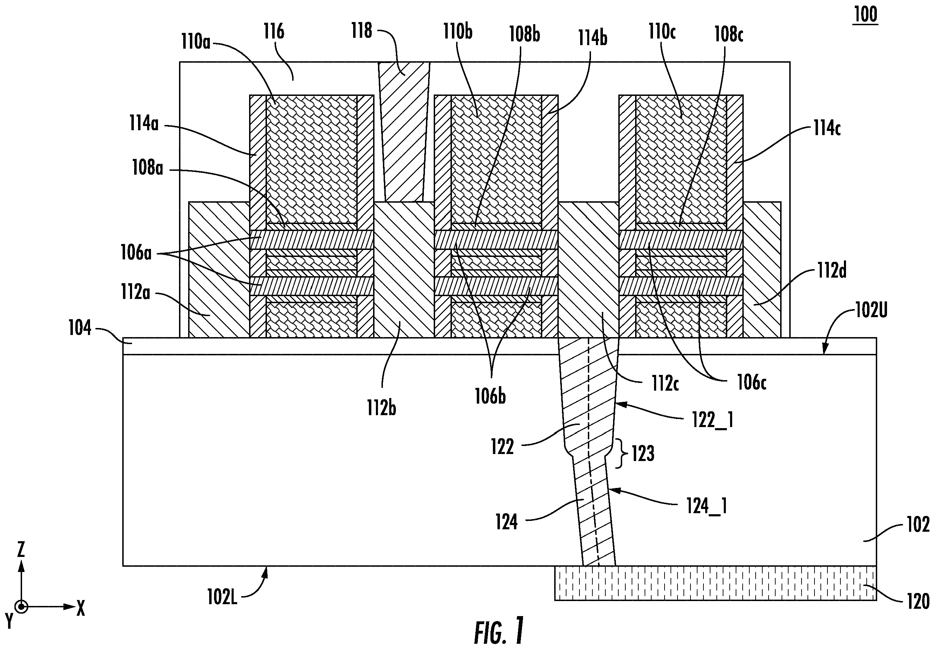

FIG. 1 is a cross-sectional view of a first integrated circuit device 100 according to some embodiments. The first integrated circuit device 100 may include a first transistor, a second transistor, and a third transistor on a substrate 102 (also referred to as a backside insulator) that includes an upper surface 102U and a lower surface 102L. However, the present inventive concept is not limited to the number of the transistors. In some embodiments, the upper surface 102U of the substrate 102 may extend in a first direction X (also referred to as a first horizontal direction) and a second direction Y (also referred to as a second horizontal direction). The upper surface 102U of the substrate 102 may be parallel to the lower surface 102L of the substrate 102. Accordingly, both the first direction X and the second direction Y may be parallel to the upper surface 102U and the lower surface 102L of the substrate 102. In some embodiments, the first direction X may be perpendicular to the second direction Y.

The substrate 102 may include semiconductor material(s), for example, Si, Ge, SiGe, GaP, GaAs, SiC, SiGeC and/or InP or may include insulating material(s), for example, silicon oxide, silicon oxynitride, silicon nitride, silicon carbonitride and/or a low-k material. In some embodiments, the substrate 102 may be a bulk substrate (e.g., a bulk silicon substrate) or a semiconductor on insulator (SOI) substrate. For example, the substrate 102 may be a silicon wafer or may be a single insulating layer. A thickness of the substrate 102 in a third direction Z (also referred to as a vertical direction) may be at least 50 nanometers (nm) (e.g., about 100 nm or greater). In some embodiments, the third direction Z may be perpendicular to the first direction X and the second direction Y. The third direction Z may be perpendicular to the upper surface 102U of the substrate 102. For example, the low-k material may include fluorine-doped silicon oxide, organosilicate glass, carbon-doped oxide, porous silicon dioxide, porous organosilicate glass, spin-on organic polymeric dielectrics and/or spin-on silicon based polymeric dielectric.

The first integrated circuit device 100 may further include an interlayer 104 that may be provided on the upper surface 102U of the substrate 102. In some embodiments, the interlayer 104 may extend between the substrate 102 and the first, second, and third transistors and may contact the upper surface 102U of the substrate 102 and the first, second, and third transistors. For example, the interlayer 104 may include insulating material(s) (e.g., silicon oxide, silicon oxynitride, silicon nitride, silicon carbonitride and/or a low-k material).

The first transistor may include a first channel region 106a. In some embodiments, the first transistor may include multiple first channel regions 106a stacked in the third direction Z, and the first channel regions 106a may be spaced apart from each other in the third direction Z, as illustrated in FIG. 1. The first transistor may also include a first gate structure that may include a first gate insulator 108a and a first gate electrode 1 10a. The first channel region 106a may extend through the first gate electrode 110a in the first direction X, and the first gate insulator 108a may be provided between the first gate electrode 110a and the first channel region 106a. The first gate insulator 108a may contact the first gate electrode 110a and the first channel region 106a.

The second transistor may include a second channel region 106b. In some embodiments, the second transistor may include multiple second channel regions 106b stacked in the third direction Z, and the second channel regions 106b may be spaced apart from each other in the third direction Z, as illustrated in FIG. 1. The second transistor may also include a second gate structure that may include a second gate insulator 108b and a second gate electrode 110b. The second channel region 106b may extend through the second gate electrode 110b in the first direction X, and the second gate insulator 108b may be provided between the second gate electrode 110b and the second channel region 106b. The second gate insulator 108b may contact the second gate electrode 110b and the second channel region 106b.

The third transistor may include a third channel region 106c. In some embodiments, the third transistor may include multiple third channel regions 106c stacked in the third direction Z, and the third channel regions 106c may be spaced apart from each other in the third direction Z, as illustrated in FIG. 1. The third transistor may also include a third gate structure that may include a third gate insulator 108c and a third gate electrode 110c. The third channel region 106c may extend through the third gate electrode 110c in the first direction X, and the third gate insulator 108c may be provided between the third gate electrode 110c and the third channel region 106c. The third gate insulator 108c may contact the third gate electrode 110c and the third channel region 106c. However, the present inventive concept is not limited to the type or shape of the first, second, and third transistors. In some embodiments, each of the first, second, and third transistors may have a structure different from those illustrated in FIG. 1. For example, each of the first, second, and third transistors may be a gate-all-around (GAA) transistor including a single channel region or a fin-shaped field-effect transistor (FinFET).

Further, the first transistor may include first and second source/drain regions 112a and 112b that may be spaced apart from each other in the first direction X, and the first gate structure may be provided between the first and second source/drain regions 112a and 112b. The first and second source/drain regions 112a and 112b may contact opposing side surfaces of the first channel region 106a, respectively, as illustrated in FIG. 1. The second transistor may include the second source/drain region 112b and a third source/drain region 112c that may be spaced apart from each other in the first direction X, and the second gate structure may be provided between the second and third source/drain regions 112b and 112c. The second and third source/drain regions 112b and 112c may contact opposing side surfaces of the second channel region 106b, respectively, as illustrated in FIG. 1. The third transistor may include the third source/drain region 112c and a fourth source/drain region 112d that may be spaced apart from each other in the first direction X, and the third gate structure may be provided between the third and fourth source/drain regions 112c and 112d. The third and fourth source/drain regions 112c and 112d may contact opposing side surfaces of the third channel region 106c, respectively, as illustrated in FIG. 1. The second source/drain region 112b and the third source/drain region 112c may also be referred to as common source/drain regions, as the second source/drain region 112b and the third source/drain region 112c are shared by the first and second transistors and second and third transistors, respectively.

Each of the first, second, and third channel regions 106a, 106b, and 106c may include semiconductor material(s) (e.g., Si, Ge, SiGe, GaP, GaAs, SiC, SiGeC and/or InP). In some embodiments, the first, second, and third channel regions 106a, 106b, and 106c may include the same material(s). In some embodiments, each of the first, second, and third channel regions 106a, 106b, and 106c may be a nanosheet that may have a thickness in a range of from 1 nm to 100 nm in the third direction Z or may be a nanowire that may have a circular cross-section with a diameter in a range of from 1 nm to 100 nm.

Each of the first, second, and third gate insulators 108a, 108b, and 108c may include a single layer or multiple layers (e.g., a silicon oxide layer and/or a high-k material layer). For example, the high-k material layer may include Al₂O₃, HfO₂, ZrO₂, HfZrO₄, TiO₂, Sc₂O₃, Y₂O₃, La₂O₃, Lu₂O₃, Nb₂O₅ and/or Ta₂O₅. In some embodiments, each of the first, second, and third gate insulators 108a, 108b, and 108c may include the same material(s).

Each of the first, second, and third gate electrodes 1 10a, 110b, and 110c may include a single layer or multiple layers. In some embodiments, each of the first, second, and third gate electrodes 110a, 110b, and 110c may include a metallic layer that includes, for example, tungsten (W), aluminum (Al), copper (Cu), molybdenum (Mo) and/or ruthenium (Ru) and may additionally include work function layer(s) (e.g., a TiN layer, a TaN layer, a TiAl layer, a TiC layer, a TiAlC layer, a TiAlN layer and/or a WN layer). In some embodiments, the first, second, and third gate electrodes 110a, 110b, and 110c may include the same material(s). The work function layer(s) may be provided between the metallic layer and the gate insulator (i.e., one of the first, second, and third gate insulators 108a, 108b, and 108c). In some embodiments, the work function layer(s) may separate the metallic layer from the gate insulator.

Each of the first, second, third, and fourth source/drain regions 112a, 112b, 112c, and 112d may include a semiconductor layer (e.g., a silicon layer and/or a silicon germanium layer) and may additionally include dopants in the semiconductor layer. In some embodiments, each of the first, second, third, and fourth source/drain regions 112a, 112b, 112c, and 112d may include a metal layer that includes, for example, W, Al, Cu, Mo and/or Ru.

The first, second, and third transistors may also respectively include first, second, and third insulating spacers 114a, 114b, and 114c (also referred to as a gate spacer or an inner gate spacer). The first insulating spacer 114a may be provided between the first gate electrode 110a and the first and second source/drain regions 112a and 112b and/or may be provided between the first gate electrode 110a and the interlayer 104. In some embodiments, opposing surfaces of the first insulating spacer 114a may respectively contact the first gate electrode 110a and one of the first and second source/drain regions 112a and 112b and may respectively contact the first gate electrode 110a and the interlayer 104. The first channel region 106a may extend through the first insulating spacer 114a in the first direction X, as illustrated in FIG. 1.

The second insulating spacer 114b may be provided between the second gate electrode 110b and the second and third source/drain regions 112b and 112c and/or may be provided between the second gate electrode 110b and the interlayer 104. In some embodiments, opposing surfaces of the second insulating spacer 114b may respectively contact the second gate electrode 110b and one of the second and third source/drain regions 112b and 112c and may respectively contact the second gate electrode 110b and the interlayer 104, as illustrated. The second channel region 106b may extend through the second insulating spacer 114b in the first direction X, as illustrated in FIG. 1.

The third insulating spacer 114c may be provided between the third gate electrode 110c and the third and fourth source/drain regions 112c and 112d and/or may be provided between the third gate electrode 110c and the interlayer 104. In some embodiments, opposing surfaces of the third insulating spacer 114c may respectively contact the third gate electrode 110c and one of the third and fourth source/drain regions 112c and 112d and may respectively contact the third gate electrode 110c and the interlayer 104. The third channel region 106c may extend through the third insulating spacer 114c in the first direction X, as illustrated in FIG. 1. Each of the first, second, and third insulating spacers 114a, 114b, and 114c may include, for example, silicon oxide, silicon oxynitride, silicon nitride, silicon carbonitride and/or a low-k material.

A first insulating layer 116 may be provided on the interlayer 104, and the first, second, and third transistors may be provided in the first insulating layer 116. For example, the first insulating layer 116 may be disposed on source/drain regions (e.g., the first, second, third, and fourth source/drain regions 112a, 112b, 112c, and 112d). Although FIG. 1 illustrates the first insulating layer 116 as a single layer, in some embodiments, the first insulating layer 116 may include multiple layers.

A source/drain contact 118 may be provided in the first insulating layer 116 on the second source/drain region 112b. The source/drain contact 118 may contact the second source/drain region 112b (e.g., an upper surface of the second source/drain region 112b). The source/drain contact 118 may electrically connect the second source/drain region 112b to a conductive element (e.g., a conductive wire or a conductive via plug) of a BEOL structure (not illustrated in FIG. 1) that is formed through the BEOL portion of device fabrication. The first, second and third transistors may be provided between the substrate 102 and the BEOL structure. However, the source/drain regions that the source/drain contact 118 contacts are not limited to the second source/drain region 112b. In some embodiments, multiple source/drain contacts may be also provided to contact other source/drain regions (e.g., the first source/drain region 112a and the second source/drain region 112b), respectively.

The interlayer 104 and the first insulating layer 116 may include, for example, silicon oxide, silicon oxynitride, silicon nitride, silicon carbonitride and/or a low-k material.

The first integrated circuit device 100 may further include a power plug 122, a power contact 124, and a backside power rail 120. The power plug 122 may be, at least partially, disposed in the interlayer 104 and in the substrate 102. In some embodiments, the power plug 122 may extend through the interlayer 104 and the substrate 102 in the third direction Z, and the power plug 122 (e.g., an upper surface of the power plug 122) may be electrically connected (e.g., contact) to the third source/drain region 112c (e.g., a lower surface of the third source/drain region 112c), as illustrated in FIG. 1. However, the source/drain regions that the power plug 122 electrically connects (e.g., contacts) are not limited to the third source/drain region 112c. Although not illustrated in FIG. 1, the power plug 122 (e.g., an upper surface of the power plug 122) may overlap in the third direction Z (e.g., contact) the second and third insulating spacers 114b and 114c. In some embodiments, the power plug 122 may overlap in the third direction Z (e.g., contact) only one of the second and third insulating spacers 114b and 114c. However, the insulating spacers that the power plug 122 overlaps in the third direction Z are not limited to the second and third insulating spacers 114b and 114c.

Although not illustrated in FIG. 1, the power plug 122 may overlap the second channel region 106b and/or the third channel region 106c. However, the channel regions that the power plug 122 overlaps in the third direction Z are not limited to the second and third channel regions 106b and 106c. Further, the second gate electrode 110b and/or the third gate electrode 110c may overlap the power plug 122 in the third direction Z. However, the gate electrodes that the power plug 122 overlaps in the third direction Z are not limited to the second and third gate electrodes 110b and 110c. As used herein, "an element A overlapping an element B in a direction X" (or similar language) means that there is at least one line that extends in the direction X and intersects both the elements A and B.

Still referring to FIG. 1, a width of the upper surface of the power plug 122 in a horizontal direction (e.g., the first direction X) may be equal to or narrower than a width of the lower surface of the third source/drain region 112c in the horizontal direction (e.g., the first direction X). However, the present inventive concept is not limited thereto. For example, the upper surface of the power plug 122 may have a width in a horizontal direction (e.g., the first direction X), which is wider than a width of the lower surface of the third source/drain region 112c in the horizontal direction (e.g., the first direction X). A side surface the power plug 122 may protrude in the horizontal direction (e.g., the first direction X) beyond a side surface of the third source/drain region 112c.

In some embodiments, a width of the power plug 122 in a horizontal direction (e.g., the first direction X) may decrease with increasing distance from the lower surface of the third source/drain region 112c in the third direction Z, as illustrated in FIG. 1. In some embodiments, a width of the power plug 122 in the second direction Y may also decrease with increasing distance from the lower surface of the third source/drain region 112c in the third direction Z. In some embodiments, a centerline in a width direction (e.g., the first direction X) of the third source/drain region 112c may be aligned and/or parallel with a centerline in the width direction of the power plug 122 (e.g., the first direction X). The centerline in the width direction of the power plug 122 is represented by the dotted line in FIG. 1.

The backside power rail 120 may be spaced apart from source/drain regions (e.g., the third source/drain region 112c) in the third direction Z. For example, the backside power rail 120 may be disposed on the lower surface 102L of the substrate 102. The substrate 102 may be disposed between source/drain regions and the backside power rail 120. Although the backside power rail 120 is illustrated as contacting the lower surface 102L of the substrate 102, in some embodiments, an intervening structure may be provided between the substrate 102 and the backside power rail 120 and may separate the substrate 102 from the backside power rail 120.

Referring to FIG. 1, the power contact 124 may be disposed in the substrate 102 between source/drain regions (e.g., the third source/drain region 112c) and the backside power rail 120. For example, the power contact 124 may be disposed between the power plug 122 and the backside power rail 120. A source/drain region (e.g., the third source/drain region 112c) may be disposed between the power contact 124 and the first insulating layer 116. In some embodiments, the power contact 124 may electrically connect a source/drain region (e.g., the third source/drain region 112c) to the backside power rail 120. For example, the power contact 124 may contact both the power plug 122 and the backside power rail 120. In some embodiments, the power contact 124 and the power plug 122 may comprise a same material. For example, the power contact 124 and the power plug 122 may have an integrated unitary structure and may be monolithic. "An integrated unitary structure" herein may mean a structure formed by the same process or the same series of processes without a structurally or visibly separated sub-part therein.

In some embodiments, a centerline in a width direction (e.g., the first direction X) of the third source/drain region 112c may be angled with respect to a centerline in the width direction (e.g., the first direction X) of the power contact 124. A centerline in a width direction (e.g., the first direction X) of the power plug 122 may be angled with respect to the centerline in the width direction (e.g., the first direction X) of the power contact 124. The centerline in the width direction of the power contact 124 is represented by the dot-dashed line in FIG. 1. In some embodiments, a side surface 122_1 of the power plug 122 and a side surface 124_1 of the power contact 124 may form a step profile at an interface 123 between the power plug 122 and the power contact 124.

In some embodiments, the centerline in the width direction of the third source/drain region 112c and the centerline in the width direction of the power contact 124 may be parallel to each other and may extend in the Z direction, and the centerline in the width direction of the power plug 122 and the centerline in the width direction of the power contact 124 may be parallel to each other and may extend in the Z direction.

In some embodiments, opposing side surfaces of the power contact 124 may be, for example, parallel to each other, but are not limited thereto. For example, the opposing side surfaces of the power contact 124 may be non-parallel. In some embodiments, the power contact 124 may have a uniform width in a horizontal direction (e.g., the first direction X). A width of the power plug 122 in a horizontal direction (e.g., the first direction X) may be wider than a width of the power contact 124 in the horizontal direction (e.g., the first direction X). For example, a width of a lower portion of the power plug 122 in a horizontal direction may be wider than a width of the power contact 124 in the horizontal direction. A thickness of the power plug 122 in the third direction Z may be thinner than a thickness of the power contact 124 in the third direction Z. For example, the thickness of the power plug 122 in the third direction Z may be at least 10 nm (e.g., from 10 nm to 60 nm). The thickness of the power contact 124 in the third direction Z may be at least 50 nm (e.g., at least 100 nm). However, the present inventive concept is not limited to the thicknesses of the power plug 122 and the power contact 124 in the third direction Z.

The backside power rail 120 may be electrically connected to a power source with a predetermined voltage (e.g., a drain voltage or a source voltage), and thus source/drain regions (e.g., the third source/drain region 112c) may be electrically connected to the power source through the power plug 122, the power contact 124, and the backside power rail 120. Each of the power plug 122, the power contact 124, and the backside power rail 120 may include, for example, metal element(s) (e.g., W, Al, Cu, Mo and/or Ru). Although not explicitly illustrated in FIG. 1, an additional structure that includes insulating layers and conductive elements (e.g., conductive wires and/or conductive vias) in the insulating layers may be provided on the backside power rail 120. The backside power rail 120 may be provided between the substrate 102 and the additional structure.

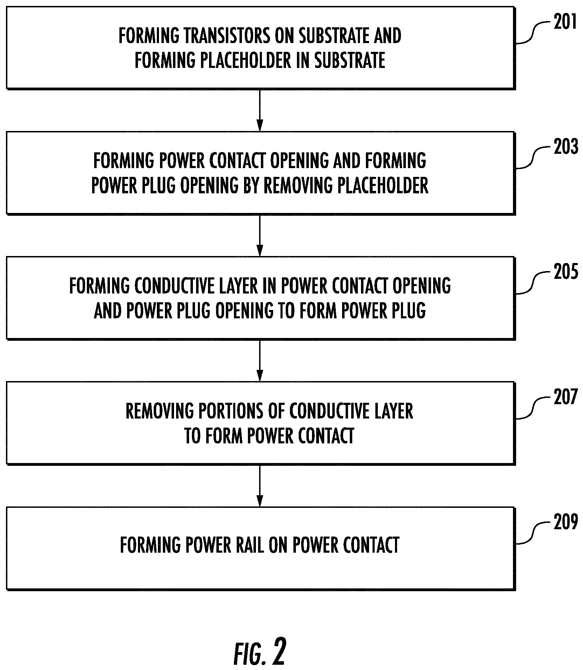

FIG. 2 is a flow chart of methods of forming an integrated circuit device (e.g., the first integrated circuit device 100) according to some embodiments.

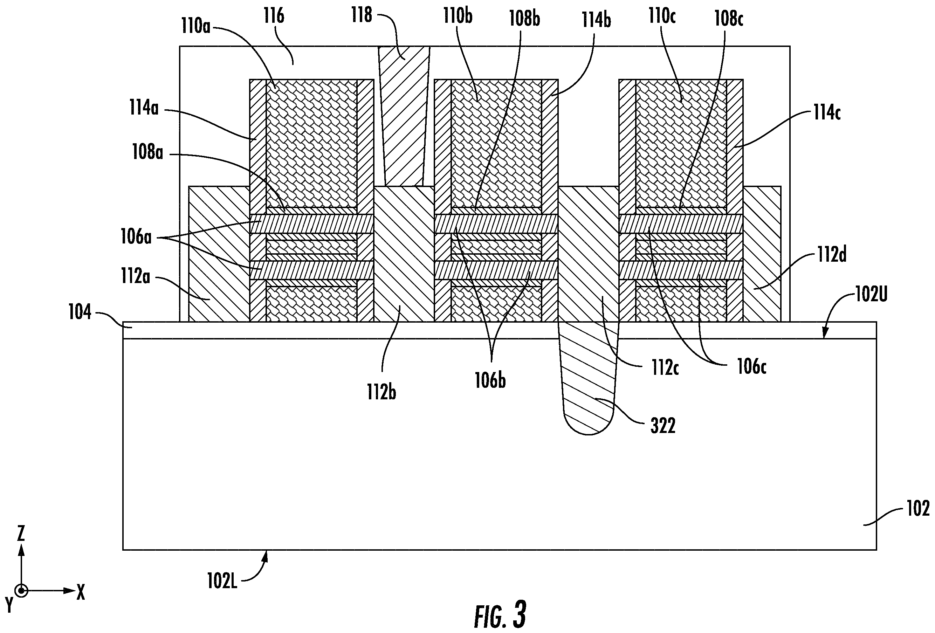

FIGS. 3 through 9 are methods of manufacturing an integrated circuit device. Referring to FIGS. 2 through 9, the methods of manufacturing an integrated circuit device (e.g., the first integrated circuit device 100 in FIG. 1) may include providing a substrate (e.g., the substrate 102 in FIG. 1) and an interlayer (e.g., the interlayer 104 discussed with reference to FIG. 1) on the substrate 102. In subsequent processes, transistors (e.g., the first, second, and third transistors in FIG. 1) may be formed on the substrate 102.

Referring to FIGS. 2 and 3, a placeholder 322 may be formed in the interlayer 104 and the substrate 102 (Block 201). The placeholder 322 may be disposed between two adjacent transistors (e.g., the second transistor and the third transistor in FIG. 1). In some embodiments, the placeholder 322 may be formed before forming at least a portion of the transistors. For example, the placeholder 322 may be formed before forming the source/drain regions (e.g., the first, second, third, and/or fourth source/drain regions 112a, 112b, 112c, and/or 112d in FIG. 1). In some embodiments, the placeholder 322 may be formed by a self-aligned etching process using the first, second, and third transistors as an etching mask before forming the source/drain regions. For example, portions of the substrate 102, which are exposed by the holes for the source/drain regions, may be etched, thereby forming an opening in the substrate 102 and then the placeholder 322 may be formed in the opening. The formation of the placeholder 322 may include etching the upper surface 102U of the substrate 102 to form an opening in the substrate 102 and then forming the placeholder 322 (e.g., a sacrificial layer) in the opening. However, the method of forming the placeholder 322 is not limited thereto. In some embodiments, the opening may be formed in the interlayer 104 and the substrate 102. In some embodiments, the placeholder 322 may be formed by adding impurities into the substrate 102 using a doping process without forming an opening. The opening may not extend completely through the substrate 102 in the third direction Z. Therefore, the placeholder 322 may not extend completely through the substrate 102 in the third direction Z.

The placeholder 322 may have a width in the first direction X decreasing in a depth direction of the opening, as illustrated in FIG. 3. An upper surface of the placeholder 322 may be coplanar with an upper surface of the interlayer 104. A lower surface of the placeholder 322 may be in the substrate 102. The placeholder 322 may include, for example, a semiconductor material and/or an insulating material (e.g., SiGe, SiN or SiBCN).

Referring to FIG. 3, the third source/drain region 112c (e.g., a lower surface of the third source/drain region 112c) may contact the placeholder 322 (e.g., an upper surface of the placeholder 322). A first insulating layer 116 may be formed on the transistors, and a source/drain contact 118 may be formed on the second source/drain region 112b and in the first insulating layer 116.

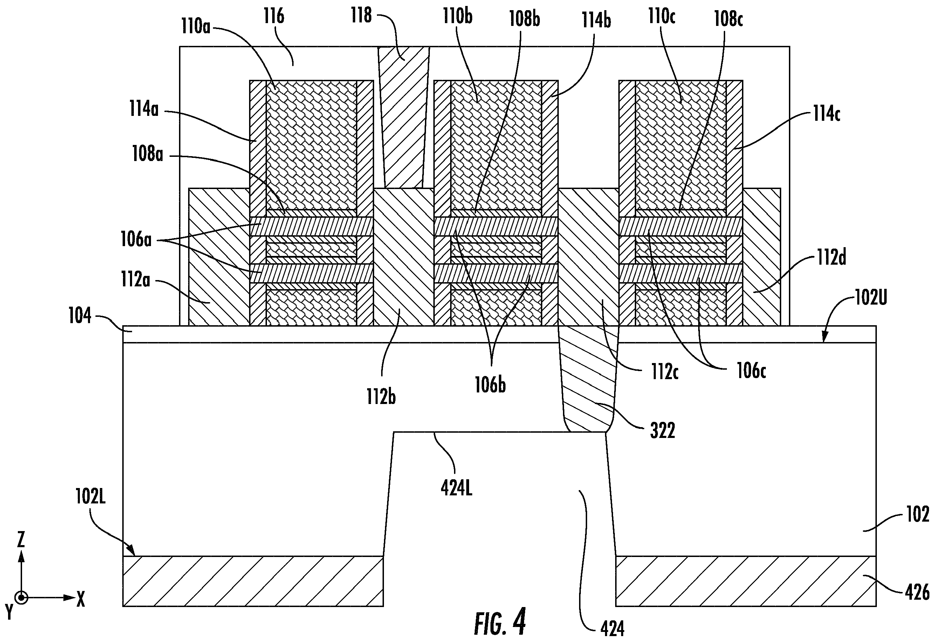

Referring to FIGS. 2 and 4, a power contact opening 424 may be formed by removing (e.g., etching) a portion of the substrate 102 by using a power contact opening mask 426 (Block 203). The power contact opening 424 may expose a lower surface of the placeholder 322. The power contact opening 424 may comprise a lower surface 424L. In some embodiments, the lower surface 424L of the power contact opening 424 may be coplanar with the lower surface of the placeholder 322. In some other embodiments, the lower surface 424L of the power contact opening 424 may not be coplanar with the lower surface of the placeholder 322. In some embodiments, a width of the power contact opening 424 in the first direction X may increase with increasing distance from the lower surface of the placeholder 322 in the third direction Z. In some embodiments, the power contact opening 424 may be symmetric with respect to a vertical line (e.g., a line extending in the third direction Z). For example, the power contact opening 424 may have a trapezoid shape in a cross-sectional view, as illustrated in FIG. 4.

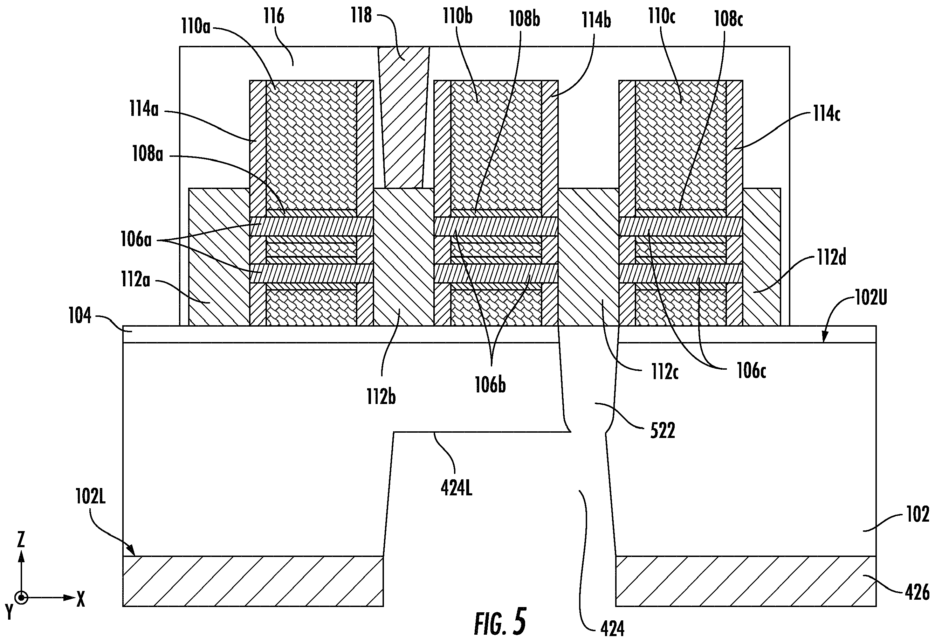

Referring to FIG. 5, the placeholder 322 may be removed by, for example, an etching process to form a power plug opening 522 (Block 203). The power plug opening 522 may expose a lower surface of a source/drain region (e.g., a lower surface of the third source/drain region 112c). Although it is not illustrated in FIG. 5, in some embodiments, the power plug opening 522 may expose a lower surface of a portion of an insulating spacer (e.g., the second insulating spacer 114b and/or the third insulating spacer 114c). In some embodiments, the power contact opening 424 and the power plug opening 522 may be formed by a same process or a same series of processes as an integrated unitary structure. A width (e.g., a widest width) of the power plug opening 522 in the first direction X may be narrower than a width (e.g., a widest width) of the power contact opening 424 in the first direction X. In some embodiments, a width (e.g., a widest width) of the power contact opening 424 in the first direction X may be at least two times a width (e.g., a widest width) of the power plug opening 522. For example, the width of the power plug opening 522 in the first direction X may be in a range of 10 nm to 40 nm (e.g., 20 nm to 30 nm), and the width of the power contact opening 424 in the first direction X may be in a range of 30 nm to 90 nm (e.g., 50 nm to 70 nm). However, the present inventive concept is not limited to the width of the power plug opening 522 or the power contact opening 424.

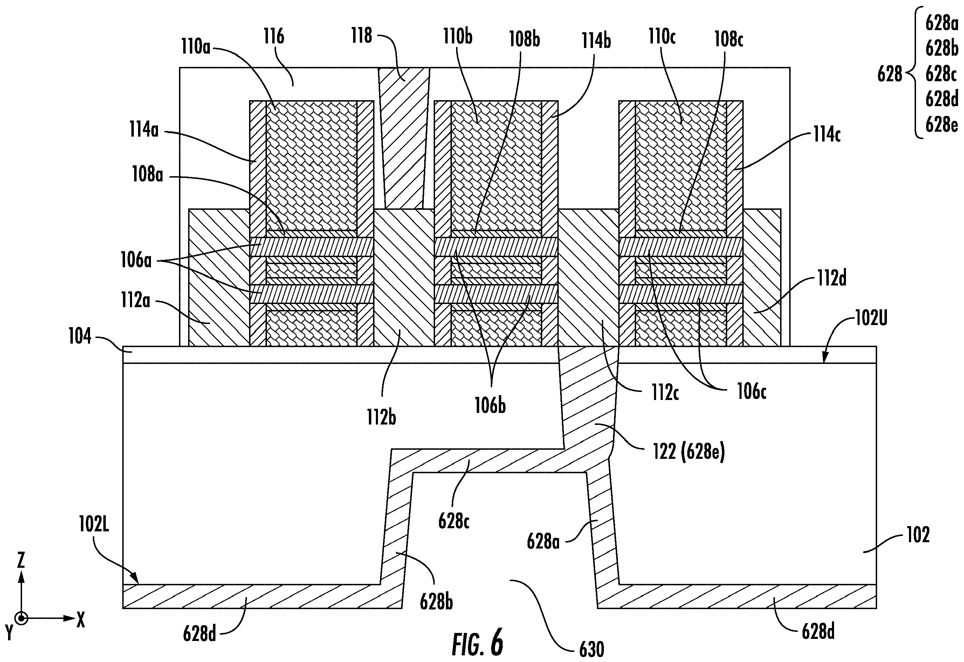

Referring to FIG. 6, in subsequent processes, the power contact opening mask 426 may be removed, and a conductive layer 628 may be formed on surfaces of the power contact opening 424 and the power plug opening 522 to form a first inner opening 630 (Block 205). For example, the conductive layer 628 may be conformally formed and extend along the surfaces of the power contact opening 424 and the power plug opening 522. The conductive layer 628 may define the first inner opening 630 within the power contact opening 424. In some embodiments, the conductive layer 628 may entirely fill the power plug opening 522 to form the power plug 122 (referring to FIG. 1) (Block 205). The conductive layer 628 may not entirely fill the power contact opening 424, and a remaining area of the power contact opening 424 after the formation of the conductive layer 628 may comprise the first inner opening 630. For example, the first inner opening 630 may be symmetric with respect to a vertical line (e.g., a line extending in the third direction Z). For example, the first inner opening 630 may have a trapezoid shape in a cross-sectional view, as illustrated in FIG. 6. The conductive layer 628 may be a single layer or may include multiple layers. The conductive layer 628 may include, for example, metal element(s) (e.g., W, Al, Cu, Mo and/or Ru).

In some embodiment, the conductive layer 628 may comprise a first portion 628a, a second portion 628b, a third portion 628c, fourth portion 628d, and fifth portion 628e. The first and second portions 628a and 628b may be on (e.g., may contact) opposing side surfaces of the power contact opening 424, respectively. The first portion 628a may overlap the power plug 122 in the third direction Z. The second portion 628b may not overlap the power plug 122 in the third direction Z. The third portion 628c may be disposed on the lower surface 424L of the power contact opening 424. The third portion 628c may extend between the first and second portions 628a and 628b in a horizontal direction (e.g., the first direction X). The third portion 628c may be in contact with the first and second portions 628a and 628b. The fourth portion 628d may be disposed on the lower surface 102L of the substrate 102. The fifth portion 628e may fill the power plug opening 522 to form the power plug 122.

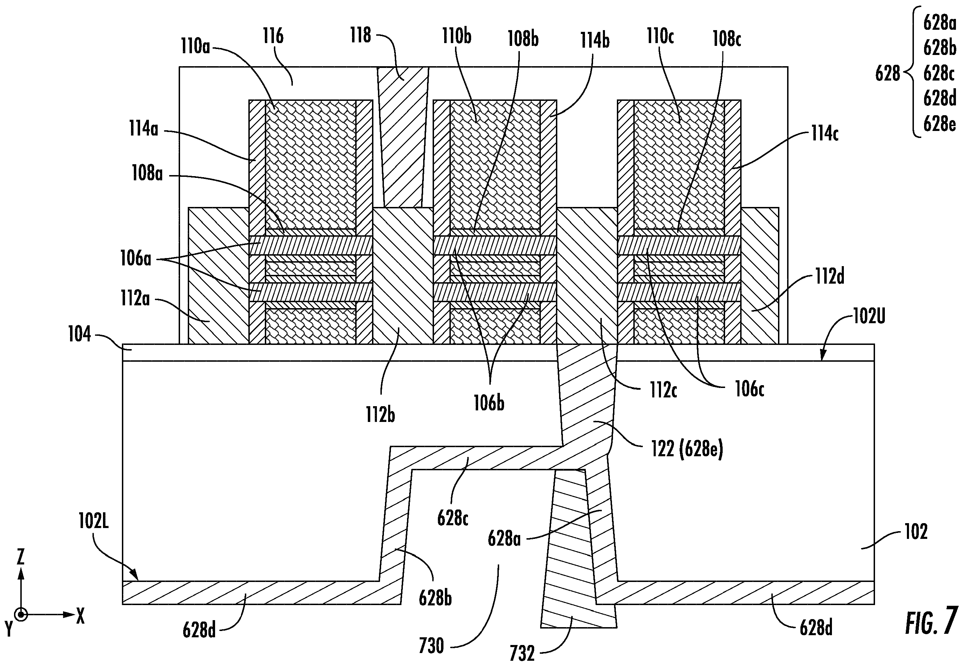

Referring to FIG. 7, a power contact mask 732 may be formed in the first inner opening 630 to form a second inner opening 730. In some embodiments, the power contact mask 732 may be formed on a side surface of the conductive layer 628. For example, the power contact mask 732 may be on (e.g., cover or contact) the first portion 628a of the conductive layer 628. In some embodiments, the power contact mask 732 may be on the third and fourth portions 628c and 628d of the conductive layer 628.

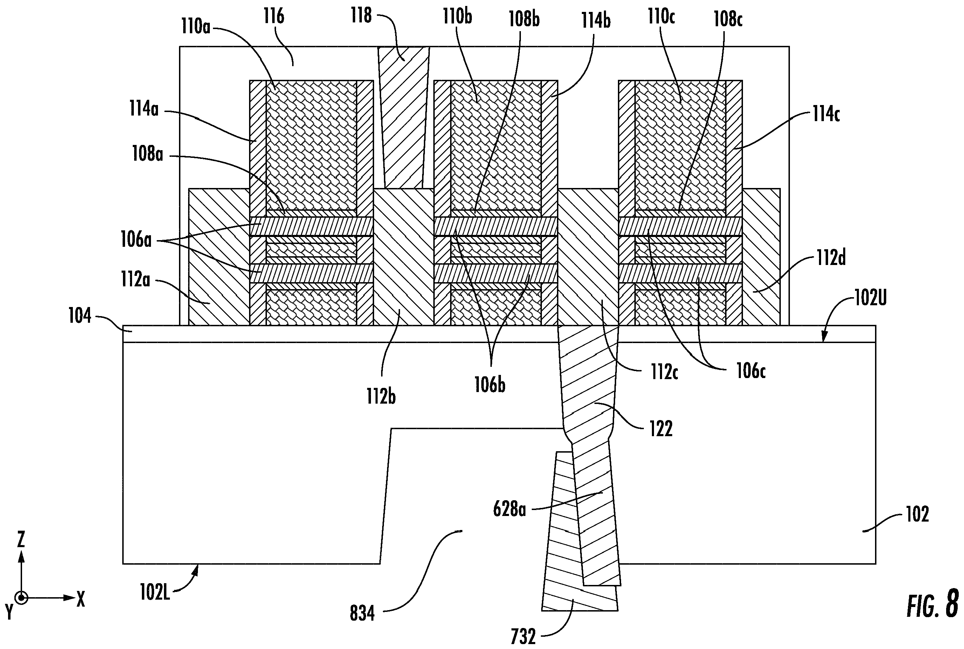

Referring to FIGS. 2 and 8, portions of the conductive layer 628 may be removed by using the power contact mask 732 as a mask to form a third inner opening 834 (Block 207). In some embodiments, portions of the conductive layer 628 that are not covered by the power contact mask 732 may be removed. For example, at least a portion of each of the second, third, and fourth portions 628b, 628c, and 628d of the conductive layer 628 may be removed. The first portion 628a (e.g., a portion of the first portion 628a) of the conductive layer 628 that is covered by the power contact mask 732 may remain.

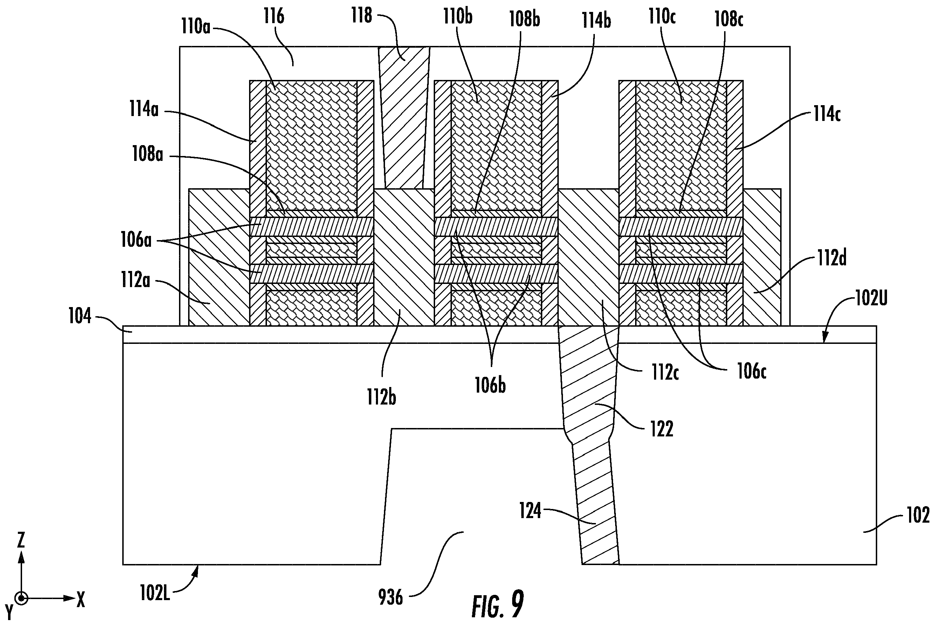

Referring to FIGS. 2 and 9, the power contact mask 732 and a portion of the first portion 628a of the conductive layer 628 may be removed to form the power contact 124 and a fourth inner opening 936 in the substrate 102. The lower surface of the power contact 124 may be coplanar with the lower surface 102L of the substrate 102. In some embodiments, the fourth inner opening 936 may be filled with an inner insulator, as illustrated in FIG. 1, through subsequent process(es). In some embodiments, the inner insulator formed in the fourth inner opening 936 may include a same material as the substrate 102. In some embodiments, the backside power rail 120 may be disposed on the power contact 124 (e.g., a lower surface of the power contact 124) and the lower surface 102L of the substrate 102(Block 209), as illustrated in FIG. 1, through subsequent process(es). In a plan view, the power contact 124 may have, for example, a parallelogram (e.g., a solid rectangular shape).

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments. For example, the first portion 628a of the conductive layer 628 may be referred to as a first portion of the conductive layer 628, and two or more of the second, third, and/or fourth portions 628b, 628c, and 628d may be collectively referred to as a second portion of the conductive layer 628.

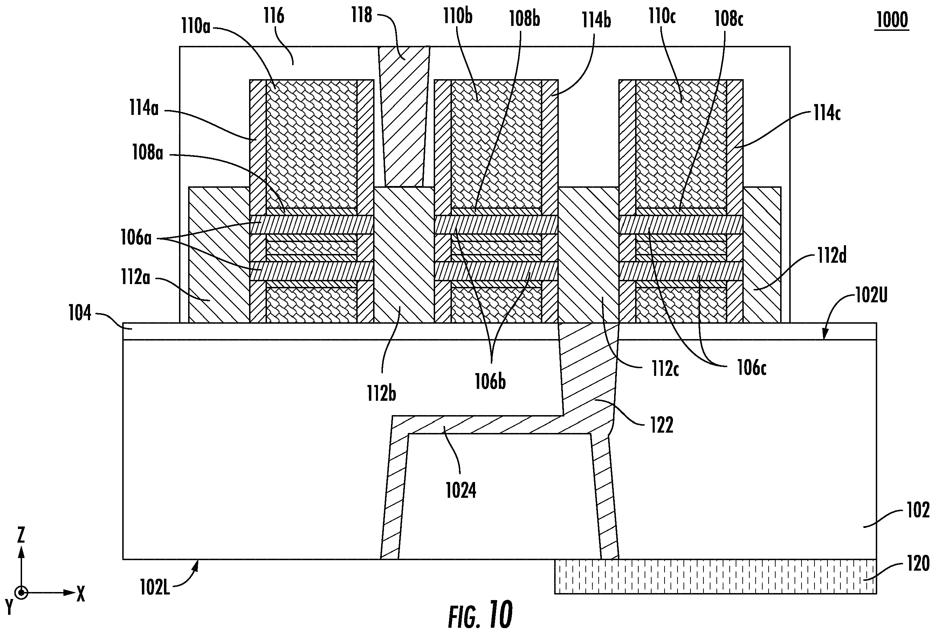

FIG. 10 is a cross-sectional view of a second integrated circuit device 1000 according to some embodiments. The second integrated circuit device 1000 is similar to the first integrated circuit device 100 in FIG. 1. The second integrated circuit device 1000 may be different from the first integrated circuit device 100, in that a power contact 1024 (corresponding to the power contact 124 in FIG. 1) may be symmetric with respect to a vertical line (e.g., a line extending in the third direction Z). The power contact 1024 may include portions (e.g., the first, second and third portions 628a, 628b, 628c of the conductive layer 628 in FIG. 6) of the conductive layer 628 formed along a surface of a power contact opening (e.g., the power contact opening 424 in FIG. 5). The power contact 1024 may include a horizontal portion extending parallel to the upper surface 102U of the substrate 102 and two protruding portions protruding from respective opposing end portions of the horizontal portion toward the lower surface of 102L of the substrate 102. In some embodiments, a distance between those two protruding portions in a horizontal direction may increase as a distance from the upper surface 102U of the substrate 102 in a vertical direction increases, as illustrated in FIG. 10. For example, the power contact 1024 may have a hollow trapezoid shape in a cross-sectional view, as illustrated in FIG. 10.

The methods of manufacturing the second integrated circuit device 1000 may include similar processes described with reference to FIGS. 3 through 6. Then, in subsequent processes, portions of the conductive layer 628 may be removed (e.g., etched) without using the power contact mask 732 (referring to FIG. 7) or by using a mask having a shape different from that of the power contact mask 732. For example, the fourth portion 628d may be entirely removed, and the first, second, and third portions 628a, 628b, and 628c may be partially removed to form the power contact 1024 in FIG. 10. In a plan view, the power contact 1024 may have, for example, a hollow rectangular shape, as illustrated in FIG. 10.

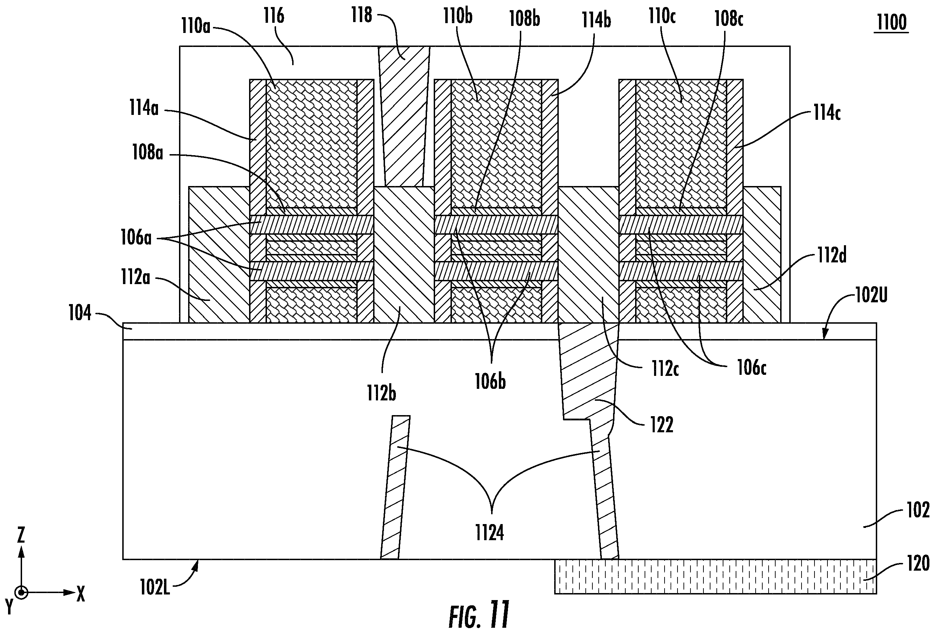

FIG. 11 is a cross-sectional view of a third integrated circuit device 1100 according to some embodiments. The third integrated circuit device 1100 is similar to the first integrated circuit device 100 in FIG. 1. The third integrated circuit device 1100 may be different from the first integrated circuit device 100, in that a power contact 1124 (corresponding to the power contact 124 in FIG. 1) may be symmetric with respect to a vertical line (e.g., a line in the third direction Z). The power contact 1124 may include portions (e.g., the first and second portions 628a and 628b of the conductive layer 628 in FIG. 6) of the conductive layer 628 formed along side surfaces of a power contact opening (e.g., the power contact opening 424 in FIG. 5). The power contact 1124 may include two portions that extend toward the lower surface of 102L of the substrate 102 and are symmetric with respect to a vertical line (e.g., a line in the third direction Z). Further, those two portions of the power contact 1124 may be spaced apart from each other in a horizontal direction, as illustrated in FIG. 11. In some embodiments, only a first portion of those two portions of the power contact 1124 may be electrically connected to the third source/drain region 112c through the power plug 122.

In some embodiments, the third integrated circuit device 1100 may include an additional backside power rail that is formed on the lower surface 102L of the substrate 102 and is spaced apart from the backside power rail 120, and a second portion of those two portions of the power contact 1124 may be electrically connected to the additional backside power rail. In some embodiments, a distance between those two portions of the power contact 1124 in a horizontal direction may increase as a distance from the upper surface 102U of the substrate 102 in a vertical direction increases, as illustrated in FIG. 10.

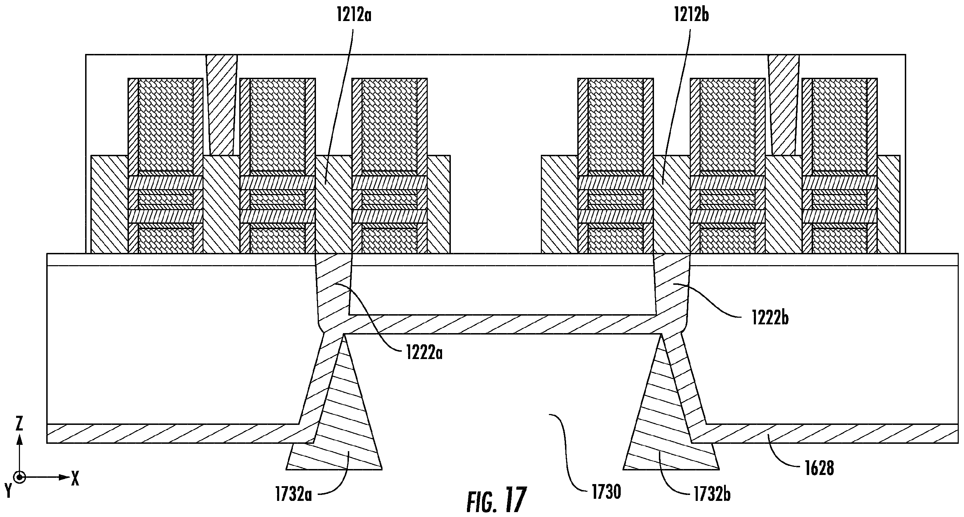

The methods of manufacturing the third integrated circuit device 1100 may include similar methods described with reference to FIGS. 3 through 6. Then, in subsequent processes, portions of the conductive layer 628 may be removed (e.g., etched) without using the power contact mask 732 (referring to FIG. 7) or by using a mask having a shape different from that of the power contact mask 732. In some embodiments, multiple etching processes using multiple etch masks may be performed to remove the portions of the conductive layer 628. For example, the third and fourth portions 628c and 628d may be entirely removed, and the first and second portions 628a and 628b may be partially removed to form the power contact 1124 in FIG. 11. In a plan view, the power contact 1124 may have, for example, a hollow rectangular shape, as illustrated in FIG. 17.

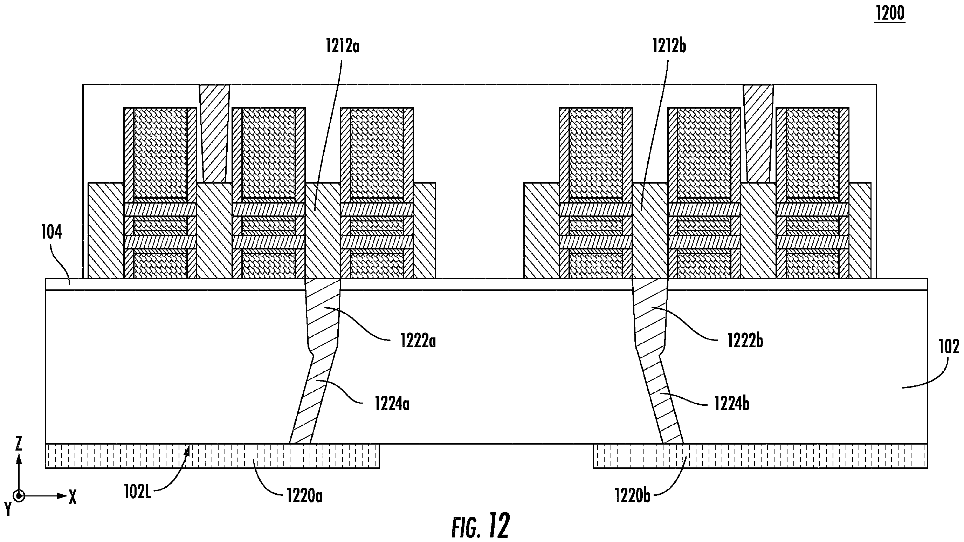

FIG. 12 is a cross-sectional view of a fourth integrated circuit device 1200 according to some embodiments. The fourth integrated circuit device 1200 is similar to the first integrated circuit device 100 in FIG. 1. The fourth integrated circuit device 1200 may be different from the first integrated circuit device 100, in that, a plurality of power contacts 1224a and 1224b (corresponding to the power contact 124 in FIG. 1) and a plurality of power plugs 1222a and 1222b (corresponding to the power plug 122 in FIG. 1) may be formed. The fourth integrated circuit device 1200 may include a first transistor having a first source/drain region 1212a and a second transistor having a second source/drain region 1212b. The fourth integrated circuit device 1200 may further include a first backside power rail 1220a and/or a second backside power rail 1220b. In some embodiments, the first backside power rail 1220a and a second backside power rail 1220b may be electrically connected to each other or may be respective portions of a common backside power rail.

In some embodiments, the plurality of power contact 1224 may comprise a first power contact 1224a and a second power contact 1224b. For example, the first and second power contacts 1224a and 1224b may be electrically connected to each other and may be portions of a common power contact. The plurality of power plug 1222 may comprise a first power plug 1222a and a second power plug 1222b. In some embodiments, the first backside power rail 1220a may be spaced apart from the first source/drain region 1212a in the third direction Z, and the second backside power rail 1220b may be spaced apart from the second source/drain region 1212b in the third direction Z. The first power contact 1224a may be between the first source/drain region 1212a and the first backside power rail 1220a. The second power contact 1224b may be between the second source/drain region 1212b and the second backside power rail 1220b. The first power contact 1224a may electrically connect the first source/drain region 1212a to the first backside power rail 1220a (through the first power plug 1222a). The second power contact 1224b may electrically connect the second source/drain region 1212b to the second backside power rail 1220b (through the second power plug 1222b). The first power contact 1224a and the second power contact 1224b may be symmetric to each other with respect to a vertical line (e.g., a line extending in the third direction Z). For example, a width of the first power contact 1224a in a horizontal direction (e.g., the first direction X) may be equal to a width of the second power contact 1224b in the horizontal direction.

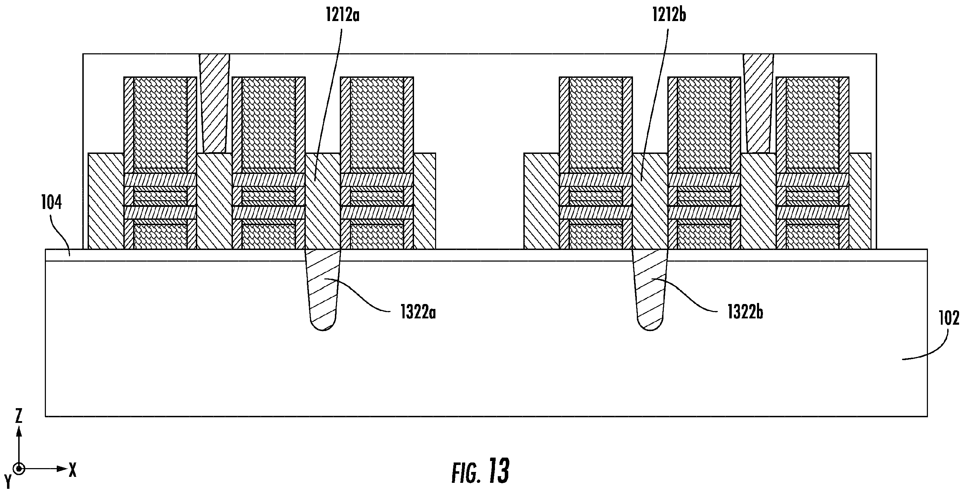

FIGS. 13 through 19 are cross-sectional views illustrating methods of manufacturing the fourth integrated circuit device 1200 in FIG. 12. Referring to FIG. 13, a first placeholder 1322a and a second placeholder 1322b may be formed in the substrate 102 and the interlayer 104. The first placeholder 1322a and the second placeholder 1322b may be spaced apart each other in a horizontal direction (e.g., the first direction X). The formation of each of the first and second placeholders 1322a and 1322b may be similar to the formation of the placeholder 322 discussed with reference to FIG. 3

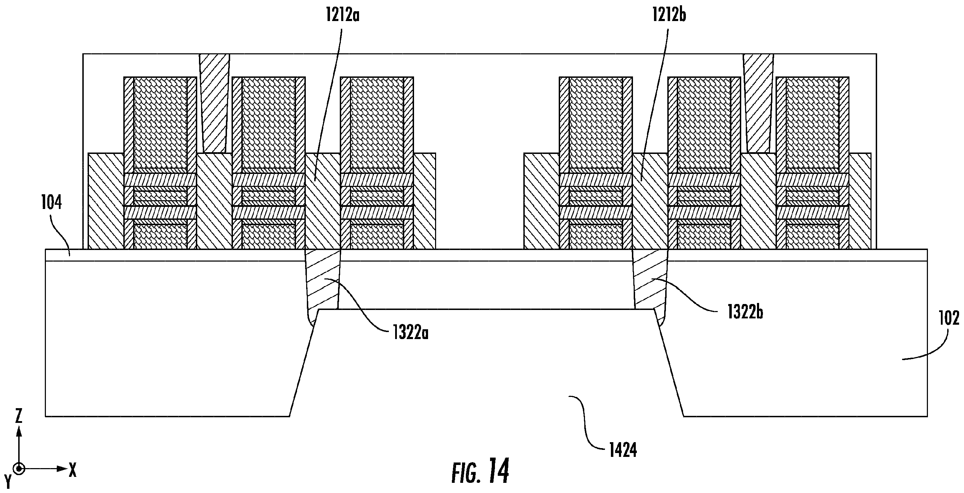

Referring to FIG. 14, a power contact opening 1424 may be formed in the substrate 102. The power contact opening 1424 may have a width in a horizontal direction (e.g., the first direction X) with a range of 30 nm to 90 nm (e.g., 50 nm to 70 nm). However, the present inventive concept is not limited to the width of the power contact opening 1424. The power contact opening 1424 may expose lower surfaces of the first and second placeholders 1322a and 1322b. In some embodiments, a width of the power contact opening 1424 in the first direction X may increase with increasing distance from the lower surfaces of the first and/or second placeholders 1322a and/or 1322b in the third direction Z. In some embodiments, the power contact opening 1424 may be symmetric with respect to a vertical line (e.g., a line extending in the third direction Z). For example, the power contact opening 1424 may have a trapezoid shape in a cross-sectional view, as illustrated in FIG. 14.

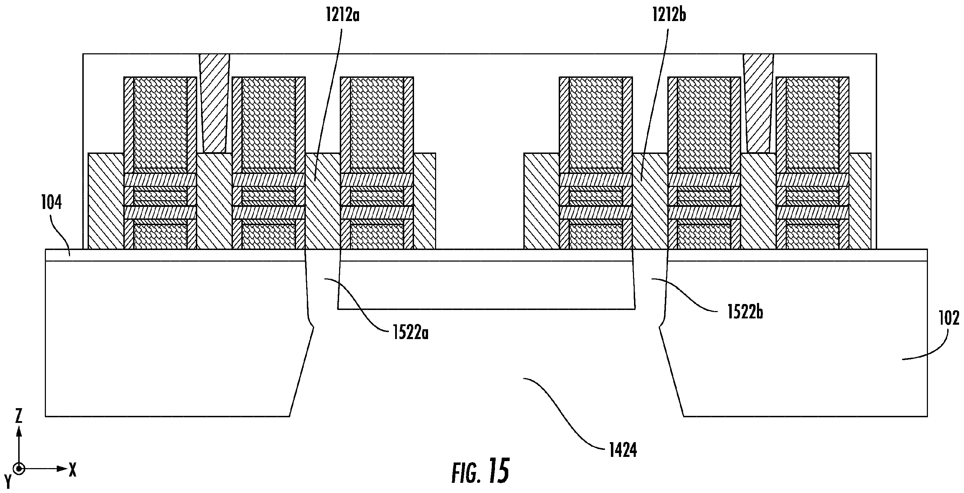

Referring to FIG. 15, the first and second placeholders 1322a and 1322b may be removed by, for example, an etching process to form a first and second power plug openings 1522a and 1522b (each corresponding to the power plug opening 522 in FIG. 5). Each of the first and second power plug openings 1522a and 1522b may have a width in a horizontal direction (e.g., the first direction X) with a range of 10 nm to 40 nm (e.g., 20 nm to 30 nm) nm. However, the present inventive concept is not limited to the width of the first and second power plug openings 1522a and 1522b. In some embodiments, the power contact opening 1424 and the first and second power plug openings 1522a and 1522b may be formed, concurrently, by a same process or a same series of processes.

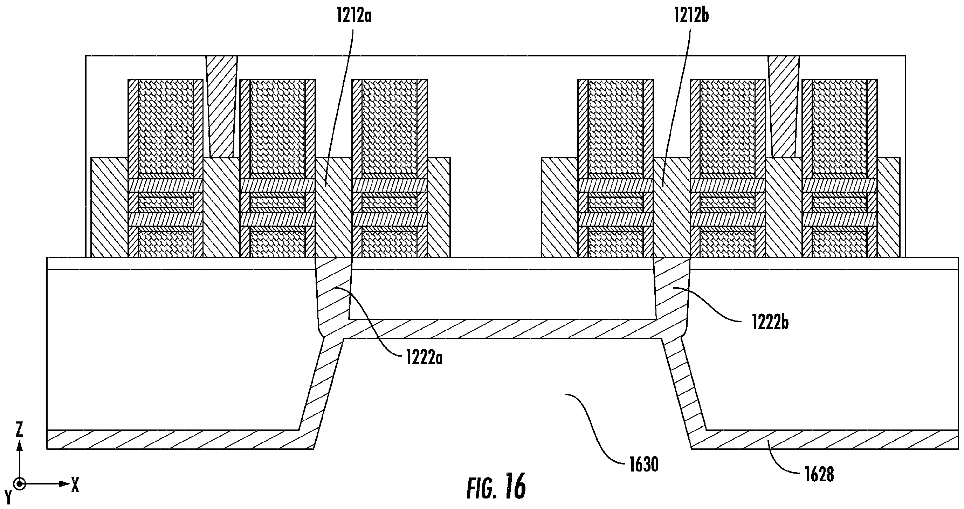

Referring to FIG. 16, in subsequent processes, a conductive layer 1628 may be formed on surfaces of the power contact opening 1424 and the first and second power plug openings 1522a and 1522b to form a first inner opening 1630. For example, the conductive layer 1628 may be conformally formed and extend along the surfaces of the power contact opening 1424 and the first and second power plug openings 1522a and 1522b. In some embodiments, the conductive layer 1628 may entirely fill the first and second power plug openings 1522a and 1522b to form first and second power plugs 1222a and 1222b (referring to FIG. 12). The conductive layer 1628 may not entirely fill the power contact opening 1424, and a remaining area of the power contact opening 1424 after the formation of the conductive layer 1628 may comprise the first inner opening 1630. For example, the first inner opening 1630 may be symmetric with respect to a vertical line (e.g., a line extending in the third direction Z). For example, the first inner opening 1630 may have a trapezoid shape in a cross-sectional view, as illustrated in FIG. 16. The conductive layer 1628 may be a single layer or may include multiple layers.

Referring to FIG. 17, a first power contact mask 1732a and a second power contact mask 1732b may be formed in the first inner opening 1630 to form a second inner opening 1730. In some embodiments, the first and second power contact masks 1732a and 1732b may be formed on opposing side surfaces of the conductive layer 1628.

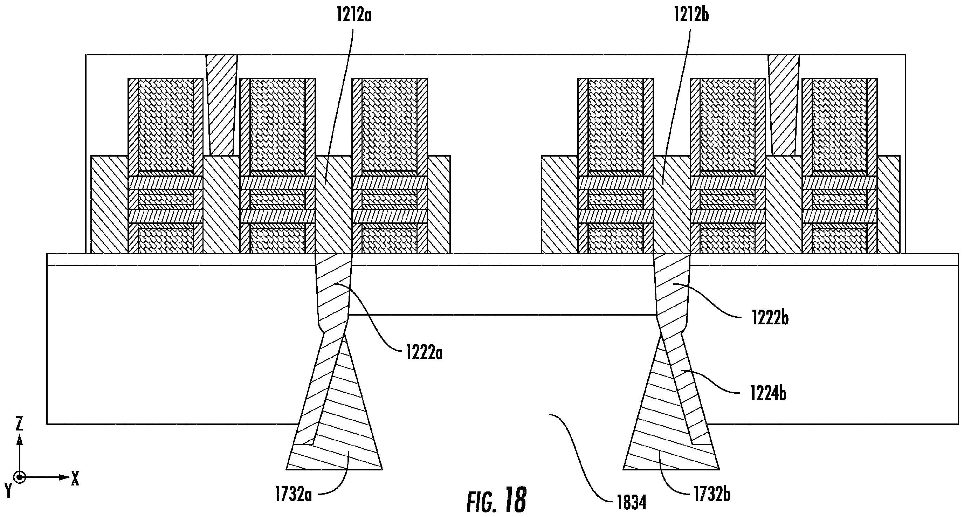

Referring to FIG. 18, portions of the conductive layer 1628 may be removed using the first and second power contact masks 1732a and 1732b as a mask to form a third inner opening 1834 and the first and second power contacts 1224a and 1224b. Portions of the conductive layer 1628 that are not covered by the first and second power contact masks 1732a and 1732b may be removed, thereby forming the first and second power contacts 1224a and 1224b.

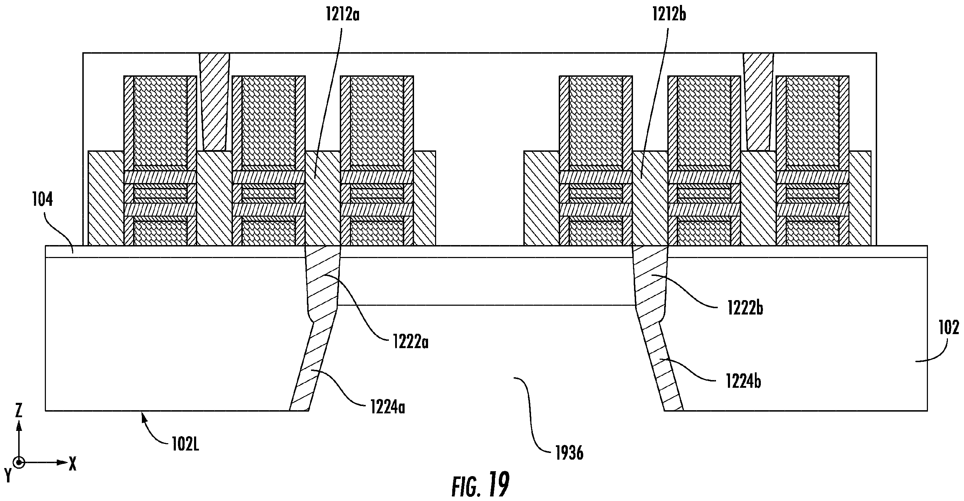

Referring to FIG. 19, the first and second power contact masks may be removed to form a fourth inner opening 1936. Referring to FIGS. 12 and 19, the fourth inner opening 1936 may be filled with an inner insulator. The inner insulator formed in the fourth inner opening 1936 may include a material the same as or different from the substrate 102. Referring to FIGS. 12 and 19, the first backside power rail 1220a and/or the second backside power rail 1220b may be disposed on the first and second power contacts 1224a and 1224b, respectively, and the lower surface 102L of the substrate 102 (Block 209). In a plan view, the first and second power contacts 1224a and 1224b may collectively form, for example, a hollow rectangular shape.

It will be understood that similar processes for manufacturing the first, second, and/or third integrated circuit devices 100, 1000, and/or 1100 (e.g., with reference to FIGS. 3 through 9) may be used in subsequent processes to form the fourth integrated circuit device 1200 with appropriate modification thereto.

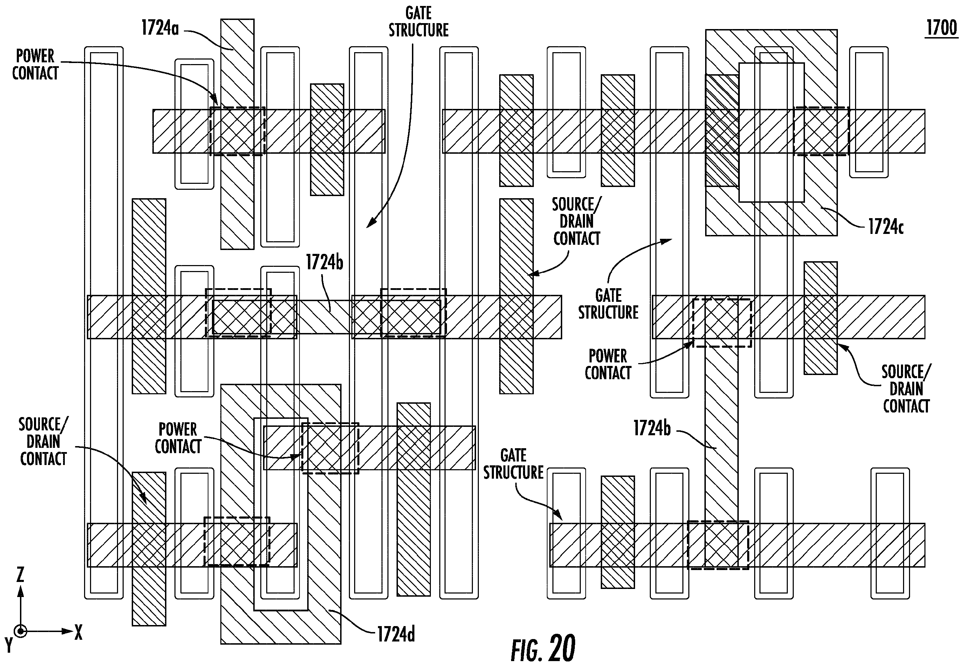

FIG. 20 is a plan view of a fifth integrated circuit device 1700 according to some embodiments. The fifth integrated circuit device 1700 may be similar to the first, second, third, and/or fourth integrated circuit devices 100, 1000, 1100, and/or 1200. The fifth integrated circuit device 1700 may include a first power contact pattern 1724a having a single power contact (corresponding to power contact 124 in FIG. 1) and a solid rectangular shape in a plan view. The fifth integrated circuit device 1700 may include a second power contact pattern 1724b having a plurality of power contacts (corresponding to the plurality of power contacts 1224 in FIG. 12) and a solid rectangular shape in a plan view. The fifth integrated circuit device 1700 may include a third power contact pattern 1724c having a single power contact (corresponding to power contact 124 in FIG. 1) and a hollow rectangular shape in a plan view. The fifth integrated circuit device 1700 may include a fourth power contact pattern 1724d having a plurality of power contacts (corresponding to the plurality of power contacts 1224 in FIG. 12) and a hollow rectangular shape in a plan view.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

In one example, when a certain embodiment may be implemented differently, processes or methods may occur in a sequence different from that specified in the description herein. For example, two consecutive processes may actually be executed at the same time. Depending on a related function or operation, the processes may be executed in a reverse sequence. Moreover, a process may be separated into multiple processes and/or may be at least partially integrated.

In descriptions of temporal relationships, for example, temporal precedent relationships between two events such as "after", "subsequent to", "before", etc., another event may occur therebetween unless "directly after", "directly subsequent" or "directly before" is not indicated.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

The above-disclosed subject matter is to be considered illustrative, and not restrictive, and the appended claims are intended to cover all such modifications, enhancements, and other embodiments, which fall within the scope of the present invention. Thus, to the maximum extent allowed by law, the scope is to be determined by the broadest permissible interpretation of the following claims and their equivalents, and shall not be restricted or limited by the foregoing detailed description.

## Claims

1. An integrated circuit device comprising:
a transistor comprising a source/drain region on a substrate;
a backside power rail spaced apart from the source/drain region, wherein the substrate is between the source/drain region and the backside power rail; and
a power contact that is between the source/drain region and the backside power rail and electrically connects the source/drain region to the backside power rail,
wherein a centerline in a width direction of the source/drain region is angled with respect to a centerline in a width direction of the power contact.

2. The integrated circuit device of Claim 1, wherein the power contact comprises opposing side surfaces that are parallel to each other.

3. The integrated circuit device of Claim 1 or 2, further comprising a power plug between the source/drain region and the power contact,
wherein the power plug is in contact with both the source/drain region and the power contact, and
wherein the centerline in the width direction of the power contact is angled with respect to a centerline in a width direction of the power plug.

4. The integrated circuit device of Claim 3, wherein side surfaces of the power plug and the power contact form a step, and
the power plug has a width wider than a width of the power contact.

5. The integrated circuit device of Claim 4, wherein a thickness of the power plug is thinner than a thickness of the power contact.

6. The integrated circuit device of any one of Claims 1 to 5, wherein the transistor further comprises a channel region,
the source/drain region is a first source/drain region contacting a first side surface of the channel region and the transistor further comprises a second source/drain region contacting a second side surface of the channel region,
the integrated circuit device further comprises:
a first insulating layer on the first and second source/drain regions, wherein the first source/drain region is between the power contact and the first insulating layer; and
a source/drain contact that is in the first insulating layer and contacts the second source/drain region.

7. The integrated circuit device of any one of Claims 1 to 6, wherein the transistor is a first transistor, the source/drain region is a first source/drain region, the backside power rail is a first backside power rail, and the power contact is a first power contact,
wherein the integrated circuit device further comprises:
a second transistor comprising a second source/drain region;
a second backside power rail spaced apart from the second source/drain region in a vertical direction; and
a second power contact that is between the second source/drain region and the second backside power rail and electrically connects the second source/drain region to the second backside power rail, and
wherein a centerline in a width direction of the second source/drain region is angled with respect to a centerline in a width direction of the second power contact.

8. The integrated circuit device of Claim 7, wherein the second power contact comprises opposing side surfaces that are parallel to each other.

9. The integrated circuit device of Claim 7 or 8, wherein an upper surface of the substrate faces the source/drain region, and
a distance between the first and second power contacts in a horizontal direction increases as a distance from the upper surface of the substrate increases.

10. The integrated circuit device of any one of Claims 1 to 9, wherein the power contact has a hollow rectangular shape in a plan view.

11. A method of forming an integrated circuit device, the method comprising:
providing a structure including a backside insulator and a transistor on the backside insulator, the transistor comprising a source/drain region; and
forming a power contact in the backside insulator,
wherein the power contact is electrically connected to the source/drain region, and
wherein forming the power contact comprises:
forming a power contact opening in the backside insulator;
conformally forming a power contact layer along a surface of the power contact opening, the power contact layer defining an inner opening within the power contact opening; and
forming an inner insulator in the inner opening.

12. The method of Claim 11, wherein forming the power contact further comprises removing a first portion of the power contact layer to leave a second portion of the power contact layer, and the second portion of the power contact layer extends along a side surface of the power contact opening.

13. The method of Claim 11 or 12, further comprising forming a power plug that is between the source/drain region and the power contact and electrically connects the source/drain region and the power contact,
wherein forming the power plug and the power contact comprises:
forming a power plug opening and the power contact opening in the backside insulator, wherein the power plug opening and the power contact opening are connected to each other, and the power plug opening exposes the source/drain region; and
forming a conductive layer in the power plug opening and the power contact opening, wherein the power contact layer is a first portion of the conductive layer.

14. The method of Claim 13, wherein a second portion of the conductive layer formed in the power plug opening contacts the source/drain region.

15. The method of Claim 14, wherein the power contact opening has a width at least two times a width of the power plug opening.
